# EUROPEAN PATENT APPLICATION

(11) **EP 4 503 112 A1**
(43) Date of publication of application: **05.02.2025**
(21) Application number: 23188750.6
(22) Date of filing: 31.07.2023
(51) Int. Cl.: H01L 21/822, H01L 21/8238, H01L 27/06, H01L 27/092, H01L 29/06, H01L 29/66, H01L 29/775, H01L 29/786

(54) **A CFET DEVICE AND A METHOD OF FABRICATING A CFET DEVICE**

(71) Applicant: Huawei Technologies Co., Ltd., Shenzhen, Guangdong 518129 (CN)
(72) Inventor: Yakimets, Dmitry, 80992 Munich (DE); Bhuwalka, Krishna Kumar, 80992 Munich (DE)
(74) Representative: Roth, Sebastian

(57) **Abstract**

The present disclosure relates to a complementary field effect transistor, CFET, device (1) and to a method of fabricating a CFET device (1). The CFET device (1) comprises a bottom transistor structure (10) arranged in a bottom tier of the CFET device (1), wherein the bottom transistor structure (10) comprises: at least one bottom channel (11), and a bottom gate (12) arranged to electrically control the at least one bottom channel (11). The CFET device (1) further comprises a top transistor structure (20) arranged in a top tier of the CFET device (1) above the bottom tier, wherein the top transistor structure (20) comprises: at least one top channel (21), and top gate arranged to electrically control the at least one top channel (21); wherein the at least one top channel (21) is arranged at an angle to the at least one bottom channel (11).

## Description

### TECHNICAL FIELD

The present disclosure relates to a complementary field effect transistor (CFET) device and to a method of fabricating such a CFET device.

### BACKGROUND

Transistors are an integral part of any integrated circuit for mobile or high-performance computer applications. CFETs (complimentary field effect transistors) are seen as the most likely device candidates for future semiconductor scaling. A CFET is a 3D device comprising an NFET stacked on top of a PFET, or vice-versa. As this transistor device is comprised of both N-channel and P-channel FETs, it is called complimentary FET.

In a conventional CFET, the top and bottom FETs are arranged such that their respective channels are aligned (i.e., parallel to each other). However, the conventional CFET design has several disadvantages. Firstly, it is difficult to access the terminals of the bottom device from the top. Further, in case of a monolithic CFET which is formed on a single waver, independent gates for bottom and top devices are difficult to fabricate. Even if such independent gates are fabricated, the individual gate access is challenging. A further design constraint of conventional CFETs is that the top and bottom devices generally have the same CPP (contacted poly pitch).

### SUMMARY

In view of the above, this disclosure aims to provide an improved CFET device and an improved method of processing a CFET device, which overcome the above mentioned limitations and disadvantages.

These and other objectives are achieved by the solution of this disclosure as described in the independent claims. Advantageous implementations are further defined in the dependent claims.

A first aspect of this disclosure provides a CFET device, comprising a bottom transistor structure arranged in a bottom tier of the CFET device, wherein the bottom transistor structure comprises: at least one bottom channel, and a bottom gate arranged to electrically control the at least one bottom channel. The CFET device further comprises: a top transistor structure arranged in a top tier of the CFET device above the bottom tier, wherein the top transistor structure comprises: at least one top channel, and a top gate arranged to electrically control the at least one top channel; wherein the at least one top channel is arranged at an angle to the at least one bottom channel.

This provides the advantage that, due to the misaligned channels, the access to terminals of the top and bottom transistor structures is improved. For example, it is easier to connect a top/bottom gate to a bottom/top source or drain, respectively. Such intracell routing connections are important, e.g., for SRAM or D-Flip-Flop devices.

The CFET device can form a standard cell, for example an inverter cell or a NAND cell, or a part thereof. For instance, a standard cell is a number of CFET devices and intra-cell interconnects linking these devices together.

The top and bottom transistor structures can each comprise a source and a drain electrically connected to the top respectively bottom channel. Source, drain and gate of each transistor can form terminals which can be contacted, e.g. via vertical contacting lines.

Both bottom and top transistor structures may comprise multiple channels, e.g. arranged on top of each other. For instance, each top and/or bottom channel can be formed by a nanosheet (NSh) layer. For instance, all top channels are aligned to each other (e.g., run parallel to each other) and all bottom channel are aligned to each other (e.g., run parallel to each other), and all bottom are arranged at an angle to all top channels.

The bottom gate can be arranged on or around the bottom channel and the top gate can be arranged on or around the top channel. For instance, the gates may wrap the respective channel from all sides forming a nanosheet FET with a gate all around design, they may also be arranged on top forming a regular planar FET, or they may wrap the channel from three sides (e.g., according to a typical FinFET deign). Thereby, a dielectric is arranged between each channel and the respective gate (i.e., the gates are not in direct electrical contact with the channels). The gates can electrically control the respective channels, especially the conductivity of the channels, by means of an applied gate voltage.

The top transistor structure can be an NFET, for example a NMOS (n-channel metal oxide field effect FET) and the bottom transistor structure can be a PFET, for example a PMOS (p-channel metal oxide FET), or vice versa.

In an implementation form of the first aspect, the at least one top channel is arranged perpendicular to the at least one bottom channel. This provides the advantage that the access to the terminals of the bottom transistor structure (from the top and/or bottom) is improved.

In an implementation form of the first aspect, the CFET device further comprises at least one vertical connection structure which is arranged to electrically connect the bottom transistor structure with the top transistor structure.

The at least one vertical connection structure can be a metal filled via.

For example, one of the at least one vertical connection structure is arranged to connect the bottom gate with the top gate. This provides the advantage that, despite their misalignment, the top and bottom transistor structures can be merged at their gates.

In an implementation form of the first aspect, the top transistor structure comprises a top drain arranged to electrically contact the at least one top channel, and the bottom transistor structure comprises a bottom drain arranged to electrically contact the at least one bottom channel; wherein the top drain of the top transistor structure is electrically connected to the bottom drain of the bottom transistor structure through one of the at least one vertical connection structure.

In an implementation form of the first aspect, the CFET device further comprises at least one signal routing line arranged above the top tier; wherein one of the at least one signal routing line is electrically connected to the top transistor structure from the top, and/or a further one of the at least one signal routing line is electrically connected to the bottom transistor structure from the top.

The number of the signal routing lines connected to the top gate(s) may vary depending on the exact CFET design. For example, different logical functions of standard cells comprising the CFET structure (e.g., inverter or NAND) have different arrangements.

In an implementation form of the first aspect, the at least one signal routing line is arranged parallel to the at least one top channel and at an angle to the at least one bottom channel, or the at least one signal routing line is arranged parallel to the at least one bottom channel and at an angle to the at least one top channel.

This achieves the advantage that vertical routing from the signal routing lines to the top and bottom transistor structures is facilitated and a more compact standard cell design can be realized.

In an implementation form of the first aspect, the CFET device further comprises a first buried power rail and a second buried power rail arranged below the bottom tier; wherein the first buried power rail is electrically connected to the bottom transistor structure from below, and wherein the second buried power rail is electrically connected to the top transistor structure from below.

The first buried power rail can be a power rail for VDD, and the second buried power rail for VSS, or vice versa, e.g. depending on which of the transistor structures is a PMOS and which is an NMOS.

In an implementation form of the first aspect, the bottom transistor structure comprises a bottom source arranged to electrically contact the at least one bottom channel, wherein the first buried power rail is electrically connected to the bottom source by means of a vertical line structure; and the top transistor structure comprises a top source arranged to electrically contact the at least one top channel, wherein the second buried power rail is electrically connected to the top source by means of a further vertical line structure, wherein the further vertical line structure is arranged to pass by the at least one bottom channel on one side.

Thereby, the first buried power rail can be directly connected to the bottom source by the vertical line structure without needing any staggered connections (e.g., a line structure to the top and an additional structure to the side).

The connections between the buried power rail and the sources can be established by respective further vertical connection structures (e.g., metal filled vias).

In an implementation form of the first aspect, the CFET device further comprises: a further top transistor structure arranged in the top tier of the CFET device next to the top transistor structure, wherein the further top transistor structure comprises: at least one top channel, and a top gate arranged to electrically control the at least one top channel; wherein the at least one top channel of the top transistor structure and the at least one top channel of the further top transistor structure are arranged parallel to each other and at an angle to the at least one bottom channel.

For example, the CFET device with two top transistor structures and one bottom transistor structure forms a NAND cell.

In an implementation form of the first aspect, the CFET device comprises a third buried power rail arranged below the bottom tier of the CFET device; wherein the third buried power rail is electrically connected to a top transistor structure of an adjacent CFET device.

The adjacent CFET device can be identical to the CFET device (i.e., comprise the same structures) and can be arranged next to the CFET device. The third buried power rail can be arranged below at least a part of the CFET device and the adjacent CFET device. For instance, the CFET device and the adjacent CFET device are arranged in a staggered manner, wherein the third buried power rail is arranged below and perpendicular to one of the top transistor structures of the CFET device and one of the top transistor structures of the adjacent CFET device. In this way, the CFET device and the adjacent CFET device can be arranged in a compact, and especially space-saving, manner.

In an implementation form of the first aspect, a top drain of the top transistor structure is electrically connected to a top source of the further top transistor structure.

For example, the top drain of top transistor and the top source of the further top transistor can be formed by a single contact structure at respective terminal ends of the at least one top channel of the top transistor structure and the further top transistor structure.

In an implementation form of the first aspect, the top gate of the further top transistor structure is electrically connected to a further bottom gate of the bottom transistor structure.

A second aspect of this disclosure provides a method of fabricating a CFET device. The method comprises the steps of: forming a bottom transistor structure in a bottom tier of the CFET device, wherein the bottom transistor structure comprises: at least one bottom channel, and a bottom gate arranged to electrically control the at least one bottom channel; forming a top transistor structure in a top tier of the CFET device above the bottom tier, wherein the top transistor structure comprises: at least one top channel, and a top gate arranged to electrically control the at least one top channel; and processing at least one vertical connection structure which electrically connects the bottom transistor structure with the top transistor structure; wherein the at least one top channel is arranged at an angle to the at least one bottom channel.

In an implementation form of the second aspect, the method comprises the further step of: processing at least one vertical connection structure, which electrically connects the bottom transistor structure with the top transistor structure.

In an implementation form of the second aspect, the bottom transistor structure is formed on a first substrate and the top transistor structure is formed on a second substrate; wherein complementary sections of the at least one vertical connection structure are formed on the first substrate and on the second substrate; wherein the second substrate is positioned above the first substrate such that the complementary sections of the at least one vertical connection structure on the first and the second substrate are aligned to each other; and wherein the first substrate and the second substrate are subsequently bonded to each other.

The vertical connection structure(s) can be formed on the first and/or on the second substrate prior to the bonding.

In an implementation form of the second aspect, the at least one top channel is arranged perpendicular to the at least one bottom channel.

In an implementation form of the second aspect, the top transistor structure comprises a top drain arranged to electrically contact the at least one top channel, and the bottom transistor structure comprises a bottom drain arranged to electrically contact the at least one bottom channel; wherein the top drain of the top transistor structure is electrically connected to the bottom drain of the bottom transistor structure through one of the at least one vertical connection structure.

In an implementation form of the second aspect, the method further comprises the step of forming at least one signal routing line arranged above the top tier; wherein one of the at least one signal routing line is electrically connected to the top transistor structure from the top, and/or a further one of the at least one signal routing line is electrically connected to the bottom transistor structure from the top.

In an implementation form of the second aspect, the at least one signal routing line is arranged parallel to the at least one top channel and at an angle to the at least one bottom channel, or the at least one signal routing line is arranged parallel to the at least one bottom channel and at an angle to the at least one top channel.

In an implementation form of the second aspect, the method further comprises the step of forming a first buried power rail and a second buried power rail arranged below the bottom tier; wherein the first buried power rail is electrically connected to the bottom transistor structure from below, and wherein the second buried power rail is electrically connected to the top transistor structure from below.

In an implementation form of the second aspect, the bottom transistor structure comprises a bottom source arranged to electrically contact the at least one bottom channel, wherein the first buried power rail is electrically connected to the bottom source by means of a vertical line structure; and the top transistor structure comprises a top source arranged to electrically contact the at least one top channel, wherein the second buried power rail is electrically connected to the top source by means of a further vertical line structure, wherein the further vertical line structure is arranged to pass by the at least one bottom channel on one side.

In an implementation form, the method comprises the further step of forming a further top transistor structure in the top tier of the CFET device next to the top transistor structure, wherein the further top transistor structure comprises: at least one top channel, and a top gate arranged to electrically control the at least one top channel; wherein the at least one top channel of the top transistor structure and the at least one top channel of the further top transistor structure are arranged parallel to each other and at an angle to the at least one bottom channel.

In an implementation form of the second aspect, the method comprises the further step of forming a third buried power rail arranged below the bottom tier of the CFET device; wherein the third buried power rail is electrically connected to a top transistor structure of an adjacent CFET device.

In an implementation form of the second aspect, a top drain of the top transistor structure is electrically connected to a top source of the further top transistor structure.

In an implementation form of the second aspect, the top gate of the further top transistor structure is electrically connected to a further bottom gate of the bottom transistor structure.

The CFET device according to the first aspect of the disclosure can be fabricated by the method according to the second aspect of the disclosure.

### BRIEF DESCRIPTION OF DRAWINGS

The above described aspects and implementation forms will be explained in the following description of specific embodiments in relation to the enclosed drawings, in which:
- FIG. 1: shows an isometric view of a CFET device according to an embodiment;
- FIGS. 2A-B: show a top and an isometric view of a layout of a CFET device according to an embodiment;
- FIGS. 3A-B: show schematic diagrams of a CFET device according to an embodiment;
- FIGS. 4A-E: show top and cross-sectional views of a CFET device according to an embodiment;
- FIG. 5: shows an equivalent circuit diagram of a CFET device according to an embodiment; and
- FIGS. 6A-C: show steps of a method of fabricating a CFET device according to an embodiment.

### DETAILED DESCRIPTION OF EMBODIMENTS

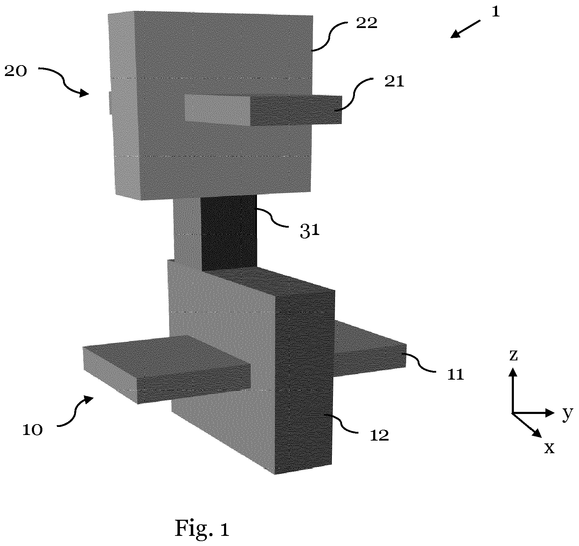

FIG. 1 shows an isometric view of a CFET device 1 according to an embodiment.

The CFET device 1 comprises a bottom transistor structure 10 arranged in a bottom tier of the CFET device 1, wherein the bottom transistor structure 10 comprises: at least one bottom channel 11 and a bottom gate 12 arranged to electrically control the at least one bottom channel 11. The CFET device 1 further comprises a top transistor structure 20 arranged in a top tier of the CFET device 1 above the bottom tier, wherein the top transistor structure 20 comprises at least one top channel 21 and a top gate 22 arranged to electrically control the at least one top channel 21; wherein the at least one top channel 21 is arranged at an angle to the at least one bottom channel 11.

The CFET structure 1 can comprise further elements, such as respective top and bottom source and drain, which are omitted in the simplified 3D view of FIG. 1.

The relative terms "above" and "below" indicate a vertical arrangement, along a z-direction in FIG. 1. These relative terms could also be swapped depending on which side of the CFET device 1 is considered the top and which is considered the bottom side. The bottom and top transistor structures 10, 20 can be stacked along the z-direction.

The top tier and the bottom tier can be levels of the CFET device 1 which are arranged on top of each other.

The at least one top channel 21 and the at least one bottom channel 11 can each comprise nanosheet (NSh) channels, i.e. each individual top/bottom channel can be formed by a nanosheet layer. The top respectively bottom gate 22, 12 can be formed around the respective channels 21, 11 (gate all around design). Alternatively, the at least one top channel 21 and the at least one bottom channel 11 can be other types of channels, e.g. fin-like channels, 2D materials with gate on top only, etc.

As shown in FIG. 1, the top and bottom channels 21, 11 can be arranged perpendicular to each other. For instance, the bottom channel 11 can extend along an x-direction and the top channel 21 can extend along a y-direction, wherein the x- and y-directions are perpendicular to each other and to the (vertical) z-direction. However, any other non-parallel (i.e., angled) arrangement of the channels 11, 21 is possible. Due to the angled arrangement of the channels 11, 12, the access to the terminals of the bottom transistor structure 10 (from the top) and/or of the top transistor structure (from the bottom) can be improved, i.e. routability is enhanced. For instance, vertical routing lines to one transistor structure do not have to be routed around the channel of the other transistor structure. Therefore, the CFET can be more compact. Furthermore, the intracell routing (i.e., routing between bottom and top transistor structures 10, 20) can be simplified.

The CFET device 1 can further comprise at least one vertical connection structure 31 which is arranged to electrically connect the bottom transistor structure 10 with the top transistor structure 20. As shown in FIG. 1, at least one of the vertical connection structures 31 can be arranged to connect the bottom gate 12 with the top gate 31. In this way, the top and bottom gates 22, 21 can be merged.

The at least one vertical connection structure 31 can be a metal via.

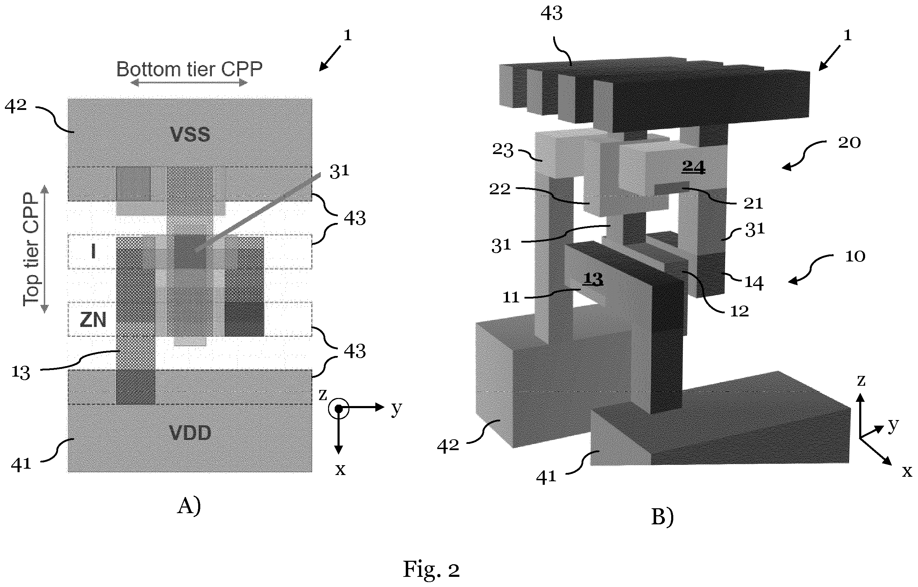

FIGS. 2A-B show different views of the CFET device 1 according to an embodiment. Thereby, FIG. 2A shows a top view and FIG. 2B shows a further isometric view, wherein a possible arrangement of additional elements of the CFET device 1, not depicted in FIG. 1, are shown. For instance, the CFET device 1 shown in FIGS. 1 and 2A-B is an inverter cell.

As shown in Figs. 2A and 2B, the top transistor structure 20 can comprise a top drain 24 and a top source 23, wherein both top drain 24 and top source 23 are arranged to electrically contact (e.g., on or around) the at least one top channel 21. Likewise, the bottom transistor structure 10 can comprise a bottom drain 14 and a bottom source 13, wherein both bottom drain 14 and bottom source 13 are arranged to electrically contact (e.g., on or around) the at least one bottom channel 11.

The top drain 24 can be electrically connected to the bottom drain 14 through a further one of the at least one vertical connection structures 31 (e.g., a further via). In this way, a CFET device 1 with an inverter architecture can be realized.

The CFET device 1 may further comprise at least one signal routing line 43 arranged above the top tier. In Figs. 2A-B, four signal routing lines 43 are shown.

As shown in FIG. 2B, one of the at least one signal routing lines 43 can be electrically connected to the top transistor structure 20 from the top, and a further one of the at least one signal routing line 43 can be electrically connected to the bottom transistor structure 10 from the top.

The signal routing lines 43 can thereby be arranged parallel to the at least one top channel 21 and at an angle, e.g. perpendicular, to the at least one bottom channel 11. However, it is also possible that the lines 43 are arranged parallel to the at least one bottom channel 11 and at an angle to the at least one top channel 21.

For instance, in case of a CFET device 1 which forms an inverter, a first signal routing line 43 forms an input (marked by "I" in FIG. 2A) and a second signal routing line forms an output (marked by "ZN" in FIG. 2A). The interconnected top and bottom gates 12, 22 can be switched by signals applied to the input line I, and the inverter can be read out via the output line ZN.

The signal routing lines 43 can be (bottom-most horizontal) routing tracks. The signal routing lines can be formed by horizontal metal layers, e.g. metal intermediate (Mint) layers.

In the depicted CFET design, the position and arrangement of the top transistor structure 20 allow to efficiently intercept the horizontal signal routing lines 43 so that it is easier to enable an access to the terminals of the transistor structures 10, 20. For example, the top transistor structure 20 is an NFET device and the bottom transistor structure 10 is a PFET device, or vice versa.

The CFET device 1 can further comprise a first buried power rail 41 and a second buried power rail 42, each arranged below the bottom tier (and, thus, below the bottom transistor structure 10). The first buried power rail 41 can be electrically connected to the bottom transistor structure 10 from below, and the second buried power rail 42 can be electrically connected to the top transistor structure 20 from below.

The buried power rails (BPRs) 41, 42 can be power rails (e.g., horizontally arranged metallic lines) which provide a power supply to the transistor structures 10, 20. The BPRs 41, 42 can be arranged in a substrate below the bottom tier (respectively, below the bottom transistor structure 10). Thus, the BPRs 41, 42 and the signal routing lines 43 can be arranged on opposite sides of the transistor structures 10, 20.

For instance, the first buried power rail 41 is configured to supply a VDD (i.e., a supply voltage), and the second buried power rail 42 is configured to supply a VSS (i.e., a ground / supply voltage), or vice versa depending on a PMOS, NMOS arrangement.

For instance, in the inverter design shown in Figs. 2A and 2B, the first buried power rail 41 is electrically connected to the bottom source 13 by means of a vertical line structure, and the second buried power rail 42 is electrically connected to the top source 23 by means of a further vertical line structure. Due to the non-parallel arrangement of the top and bottom channels 21, 11, the further vertical line structure (which electrically connects the BPR and the top transistor) can be a 1D structure which passes by the bottom channel 11 on one side. For instance, the vertical line structure and the further vertical line structure are metal filled vias.

The top and bottom channels 21, 11 of both transistor structures 20, 10 not being parallel can make it easier to connect to the terminals (e.g. gate, source, drain) on these channels 21, 11 from the top and from the bottom. Furthermore, both BPRs 41, 42 (for the top and bottom transistor structure 20, 10) can be arranged below the bottom transistor structure 10, which reduces the size of the CFET device 1, in comparison to a CFET having power rails which are arranged to the sides of the top and/or bottom transistors 10, 20 (e.g., in the top and/or bottom tier).

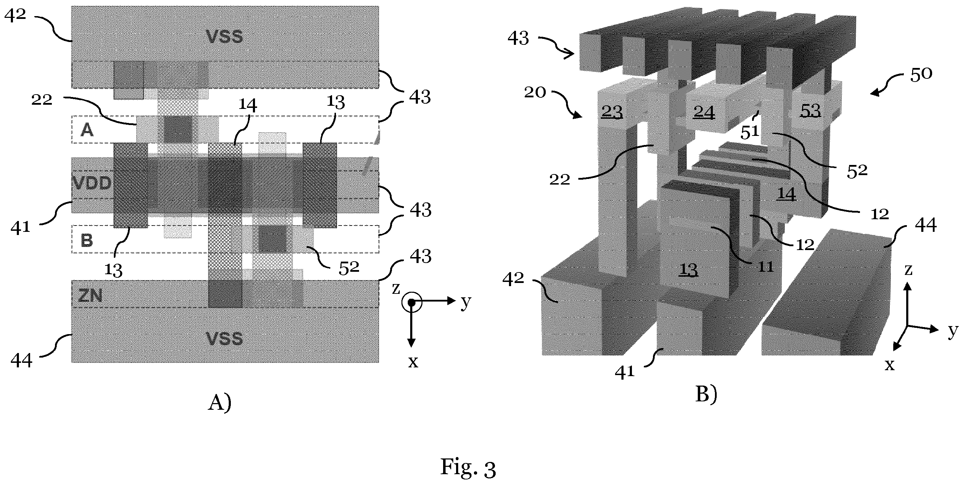

FIGS. 3A-B show schematic diagrams of the CFET device 1 according to an embodiment. For instance, the CFET device 1 shown in FIGS. 3A-B is a NAND cell.

The CFET device 1 shown in FIGS. 3A and 3B comprises the top transistor structure 20 and a further top transistor structure 50, both arranged next to each other and, e.g., offset lengthwise in the top tier of the CFET device 1. The further top transistor structure 50 can comprise at least one top channel 51, a top gate 52 arranged to electrically control the at least one top channel 51, and a top drain 53 arranged to electrically contact the at least one top channel 51. Both the top gate 52 and the top drain 53 can be arranged on or around the top channel 51. Thereby, the at least one top channel 21 of the top transistor structure 20 and the at least one top channel 51 of the further top transistor structure 50 are arranged parallel to each other and at an angle, e.g. perpendicular, to the at least one bottom channel 11.

As it can be seen in FIG. 3B, the buried power rail 42, which provides the VSS power supply, can be connected to the top source 23 of the (first) top transistor structure 20 via a vertical connection line (similar to the inverter design of FIG. 2A-B).

As the top tier transistor structures 20, 50 of the CFET device 1 are of the same polarity (e.g., NFET or PFET), they are both connected to the same buried power rail (VSS or VDD, respectively). Furthermore, the top transistors structures 20, 50 can be arranged to allow for an efficient input signal access to the gates 22, 52. For instance, the transistors are arranged on both sides of the bottom transistor structure 10.

To simplify the access to the buried power rails 41, 42, it is, thus, beneficial to use the same voltage potential for the outbound buried power supply rails. In the example of FIG. 3A-B, the VSS power rail 42 is used. The opposite polarity power rail 41 (VDD in the provided example) can be arranged directly underneath the bottom tier transistor structure 10. A connection to the VSS power rail 41 can be realized by vertical vias landing directly on a bottom part of the bottom source 13 of the bottom transistor structure 10.

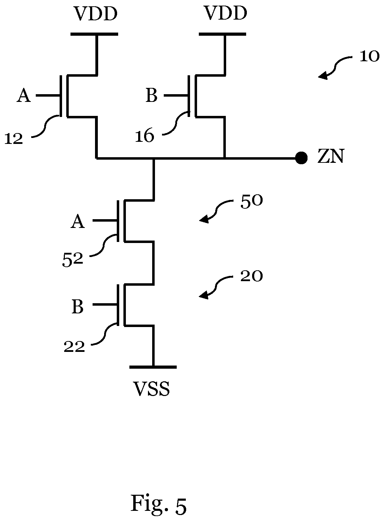

Thus, the first buried power rail 41, which provides the VDD, can be arranged directly below and parallel to the bottom channel 11 of the bottom transistor structure 10, such that a direct source back-side connection for bottom transistor structure 10 is provided. For instance, in the NAND configuration, the bottom transistor structure comprises two bottom sources 13 and two bottom gates 12, wherein the bottom gates 12 are arranged to electrically control (e.g., arranged on or around) the bottom channel 11. Thereby, the bottom gates 12 can be connected to a common drain 14, as can be seen in the equivalent circuit diagram in FIG. 5.

Furthermore, the CFET device 1 may comprise a third buried power rail 44 arranged below the bottom tier, wherein the third buried power rail 44 is electrically connected to a top transistor structure of an adjacent CFET device (not shown in FIGS. 3A-B).

The third BPR 44 can have the same polarity as the second BPR 42 which is connected to the (first) top transistor structure 20, e.g. VSS if the top transistors are NMOS. In the example shown in FIG. 3A-B, the first BPR 41 (VDD) is arranged between the second and third BPRs (VSS) 42, 44.

For instance, the CFET device 1 and the adjacent CFET device can be identical (i.e., can comprise the same elements in an equivalent arrangement) and can be are arranged in a staggered manner, with the third buried power rail 44 being arranged below and perpendicular to the further top transistor structure 50 of the CFET device 1 (and to one of the top transistor structures of the adjacent CFET device). In this way, the CFET device 1 and the adjacent CFET device can be arranged in a compact and especially space-saving manner.

Furthermore, the top drain 24 of the top transistor structure can be electrically connected to a top source of the further top transistor structure, e.g. by a direct source/drain (S/D) connection. As shown in FIG. 3B, the top drain 24 of the top transistor structure 20 and a top source of the further top transistor structure 50 can be formed by a single contact structure (with reference 24 in FIG. 3B) at respective terminal ends of the top channels 21, 51 of the top transistor structure 20 and the further top transistor structure 50 (e.g., by merging of the top M0 layers). This arrangement further improves and simplifies the intracell routing between the transistor structures 10, 20, 50 of the CFET device 1.

For instance, the top gate 52 of the further top transistor structure 50 can be electrically connected to a further bottom gate 12 of the bottom transistor structure, according to the NAND design requirements. Thereby, two signal routing line 43 (marked by "A" and "B" in FIG. 3A) can form inputs and one signal routing line 43 (marked by "ZN") can form an output of the device 1.

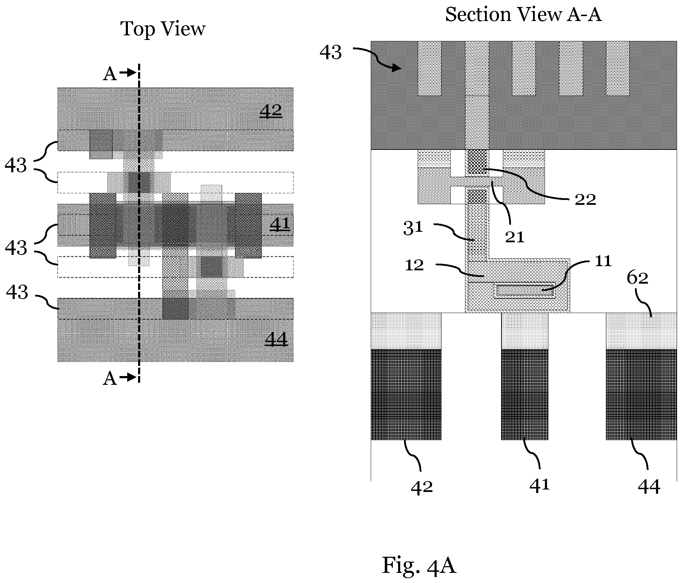

FIGS. 4A-E show cross-sectional views of the CFET device 1 in the NAND configuration, as shown in FIGS. 3A-B, according to an embodiment. Thereby, A-A respective B-B section lines which indicate the position of the cross-sections are highlighted in a top view of the CFET device 1.

The section view in FIG. 4A shows a view along the top channel 21 of the (first) transistor structure 20 and perpendicular to the bottom channel 11, wherein the bottom channel is wrapped by bottom gate 12. The buried power rails 41, 42, 44 may be covered by a capping layer 62, where they are not in electrical contact with the transistor structures 10, 20, 50. The signal routing lines 43 can be formed by a MINT layer, wherein one signal routing line 43 is connected to the top gate 22 via a MINT via. The signal routing lines 43 can be arranged in an inter-layer dielectric (ILD). The bottom gate 12 is connected to the top gate 22 by a vertical connection structure 31, e.g. a gate merge via. The bottom and top gates 12, 22, 52 can be at least partially surrounded by a gate dielectric, e.g. SiO₂ and/or HfO₂. For instance, HfO₂ arranged on the sides is a result of replacement-metal-gate (RMG) process which is typically used to form a gate. However, also other dielectrics can be arranged around the metals of the CFET, e.g. the gate, if different processing techniques are used.

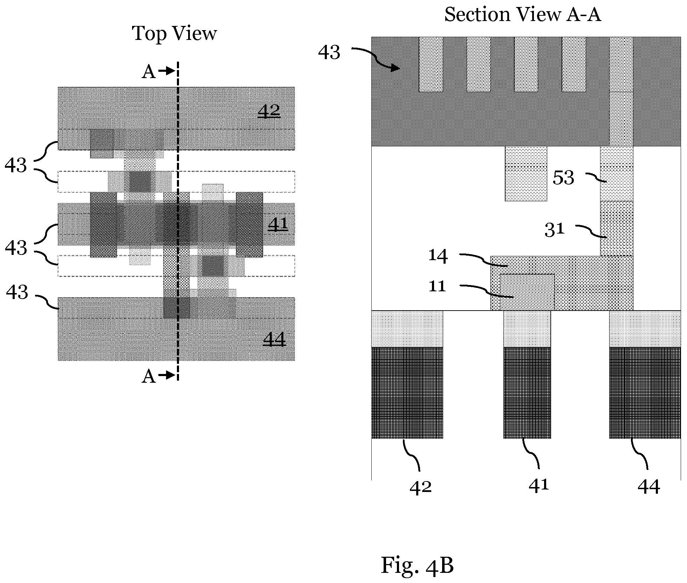

FIG. 4B shows the merging of bottom and top transistor structures 10, 20, 50 by means of a vertical connection structure 31 in order to propagate the output signal to an output signal routing line 43. In this way, the bottom drain 14 and the top drain 53 can be merged or interconnected with each other and with an (output) signal routing line 43. For instance, the bottom drain 14 and the top drain 53 can be formed by or be connected to metal zero (M0) layers.

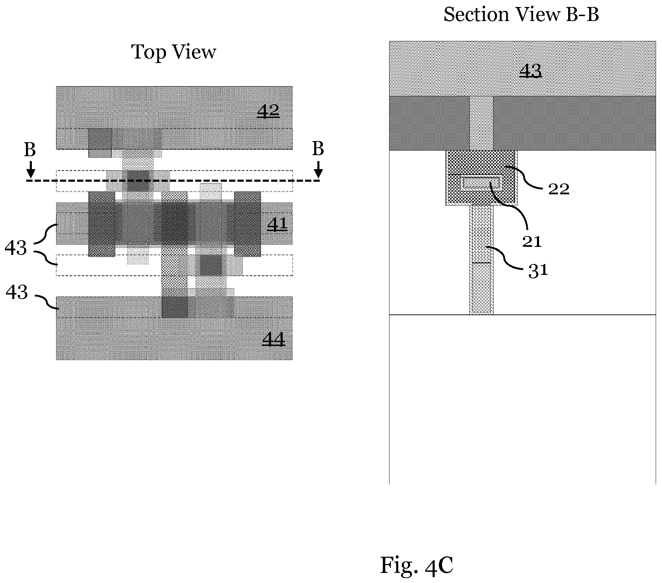

FIG. 4C shows a cross-sectional view across the at least one top channel 21, demonstrating the top gate 22 wrapping around the top channel 21 from all sides (gate all around design).

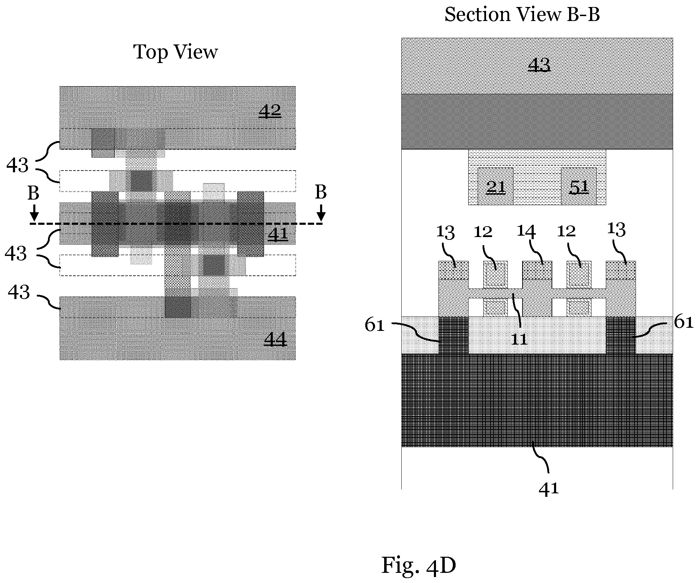

FIG. 4D shows a cross-sectional view along the bottom channel 11 and perpendicular to the top channels 21, 51. The cross-sectional view passes through two top S/D epi regions surrounded by M0 Top. Vertical line structures 61 (e.g., metal filled vias) electrically connect the buried power rail 41 with terminals of the bottom transistor structure 10.

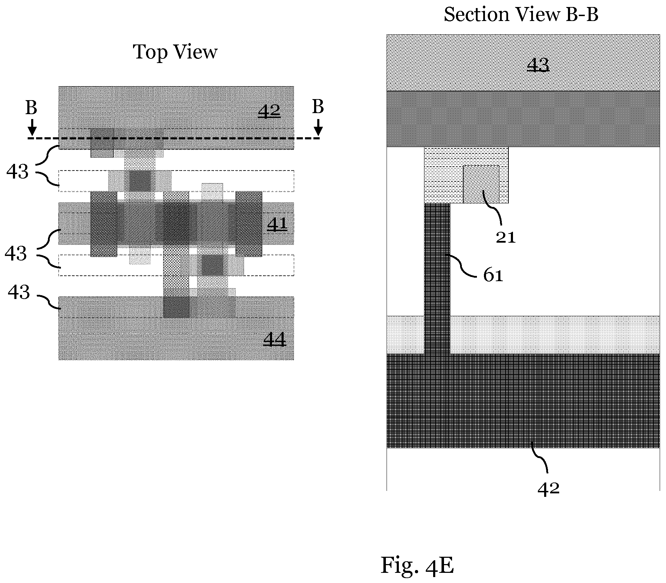

FIG. 4E shows an electrical connection of the second buried power rail 42 with the (first) top transistor structure 20, for instance with an M0 top layer, from below. Due to the arrangement of the transistor structures 10, 20, 50 this connection can be realized by a further vertical line structure 61.

In summary, the arrangement of the (first) buried power rail 41 in the center of the CFET device 1 allows to simplify the routing between adjacent top tier devices 20, 50 without excessive utilization of metal routing resources. Furthermore, a direct source 13 back-side connection for bottom tier transistor device 10 can be realized, which simplifies the power connections for top tier devices 20, 50 (e.g., via a single, vertical via 61 next to the bottom transistor structure 10). Further, the CPP of the devices in the top and bottom tier can be different, which allows for extra design flexibly with limited area penalty.

FIG. 5 shows an equivalent circuit diagram of the CFET device 1 in the NAND configuration, as e.g. shown in FIGS. 3A-B and 4A-E.

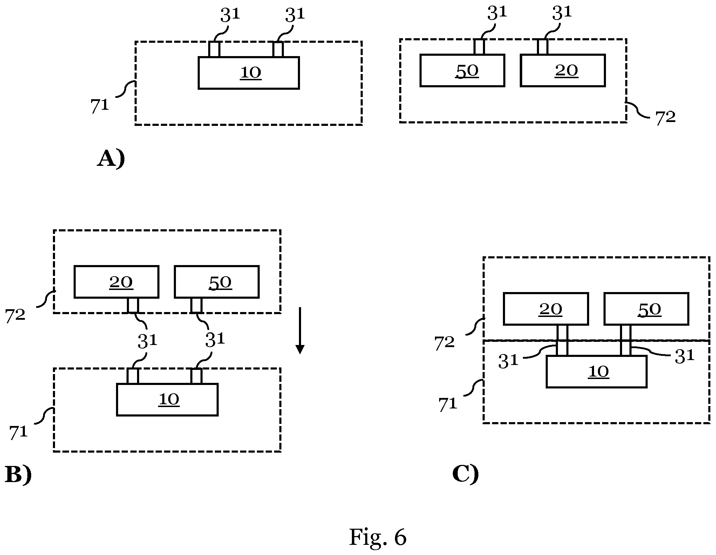

FIGS. 6A-C show steps of a method for fabricating the CFET device 1 according to an embodiment.

The method comprises: forming the bottom transistor structure 10 in the bottom tier of the CFET device 1, wherein the bottom transistor structure 10 comprises the at least one bottom channel 11, and the bottom gate 12 arranged to electrically control (e.g., arranged on or around) the at least one bottom channel 11; and further forming a top transistor structure 20 in the top tier of the CFET device 1 above the bottom tier, wherein the top transistor structure 20 comprises the at least one top channel 21, and the top gate 22 arranged to electrically control (e.g., arranged on or around) the at least one top channel 21.

In the depicted example, the further top transistor structure 50 is formed in the top tier of the CFET device 1 next to the top transistor structure 20.

The method may further comprise processing the at least one vertical connection structure 31 which electrically connects the bottom transistor structure 10 with the top transistor structure(s) 20, 50 in the fabricated CFET device 1.

In FIGS. 6A-C, the fabrication is shown as a sequential integration process, wherein the top and bottom transistor structures 10, 20, 50 are formed on a first and a second substrate 71, 72 (e.g., wafers), respectively (as shown in FIG. 6A), and are subsequently brought together by a hybrid wafer bonding process (as shown in FIGS. 6B-C). Thereby, complementary sections of the at least one vertical connection structure 31 (e.g., vias) can be formed on the first substrate 71 and on the second substrate 72 prior to bonding. Then, the second substrate 72 is positioned above the first substrate 71 such that the complementary sections of the at least one vertical connection structure 31 on the first and the second substrate 71, 72 are aligned to each other. Subsequently, the first substrate 71 and the second substrate 72 are bonded to each other.

This sequential approach provides high flexibility in the top tier device design. However, it is also possible to fabricate the CFET device 1 with a monolithic integration, where all transistor structures 10, 20, 50 are formed on a single substrate.

In the resulting CFET device 1, the at least one top channel 21 of the top transistor structure 10 is arranged at an angle to the at least one bottom channel 11 of the bottom transistor structure 10.

Furthermore, in the resulting CFET device 1, the at least one channel 51 of the further top transistor structures 50 can be arranged parallel to the at least one channel 21 of the top transistor structure 10 and at an angle to the at least one bottom channel 11.

The CFET device 1 may be comprised by a processor or processing circuitry (not shown) configured to perform, conduct or initiate various operations. The processing circuitry may comprise hardware and/or the processing circuitry may be controlled by software. The hardware may comprise analog circuitry or digital circuitry, or both analog and digital circuitry. The digital circuitry may comprise components such as application-specific integrated circuits (ASICs), field-programmable arrays (FPGAs), digital signal processors (DSPs), or multipurpose processors. The device may further comprise memory circuitry, which stores one or more instruction(s) that can be executed by the processor or by the processing circuitry, in particular under control of the software. For instance, the memory circuitry may comprise a non-transitory storage medium storing executable software code which, when executed by the processor or the processing circuitry, causes the various operations of the device to be performed. In one embodiment, the processing circuitry comprises one or more processors and a non-transitory memory connected to the one or more processors.

The present disclosure has been described in conjunction with various embodiments as examples as well as implementations. However, other variations can be understood and effected by those persons skilled in the art and practicing the claimed matter, from the studies of the drawings, this disclosure and the independent claims. In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation.

## Claims

1. A complementary field effect transistor, CFET, device (1), comprising:
a bottom transistor structure (10) arranged in a bottom tier of the CFET device (1), wherein the bottom transistor structure (10) comprises:
- at least one bottom channel (11), and
- a bottom gate (12) arranged to electrically control the at least one bottom channel (11);
a top transistor structure (20) arranged in a top tier of the CFET device (1) above the bottom tier, wherein the top transistor structure (20) comprises:
- at least one top channel (21), and
- a top gate arranged to electrically control the at least one top channel (21);
wherein the at least one top channel (21) is arranged at an angle to the at least one bottom channel (11).

2. The CFET device (1) of claim 1,
wherein the at least one top channel (21) is arranged perpendicular to the at least one bottom channel (11).

3. The CFET device (1) of claim 1 or 2, further comprising:
at least one vertical connection structure (31) which is arranged to electrically connect the bottom transistor structure (10) with the top transistor structure (20).

4. The CFET device (1) of claim 3,
wherein the top transistor structure (20) comprises a top drain (24) arranged to electrically contact the at least one top channel (21), and the bottom transistor structure (10) comprises a bottom drain (14) arranged to electrically contact the at least one bottom channel (11);
wherein the top drain (24) of the top transistor structure (20) is electrically connected to the bottom drain (14) of the bottom transistor structure (10) through one of the at least one vertical connection structure (31).

5. The CFET device (1) of any one of the preceding claims, further comprising:
at least one signal routing line (43) arranged above the top tier,
wherein one of the at least one signal routing line (43) is electrically connected to the top transistor structure (20) from the top, and/or a further one of the at least one signal routing line (43) is electrically connected to the bottom transistor structure (10) from the top.

6. The CFET device (1) of claim 5,
wherein the at least one signal routing line (43) is arranged parallel to the at least one top channel (21) and at an angle to the at least one bottom channel (11), or
wherein the at least one signal routing line (43) is arranged parallel to the at least one bottom channel (11) and at an angle to the at least one top channel (21).

7. The CFET device (1) of any one of the preceding claims, further comprising:
a first buried power rail (41) and a second buried power rail (42) arranged below the bottom tier;
wherein the first buried power rail (41) is electrically connected to the bottom transistor structure (10) from below, and wherein the second buried power rail (42) is electrically connected to the top transistor structure (20) from below.

8. The CFET device (1) of claim 7,
wherein the bottom transistor structure (10) comprises a bottom source (13) arranged to electrically contact the at least one bottom channel (11), wherein the first buried power rail (41) is electrically connected to the bottom source (13) by means of a vertical line structure (61); and
wherein the top transistor structure (20) comprises a top source (23) arranged to electrically contact the at least one top channel (21), wherein the second buried power rail (42) is electrically connected to the top source (23) by means of a further vertical line structure (61), wherein the further vertical line structure (61) is arranged to pass by the at least one bottom channel (11) on one side.

9. The CFET device (1) of any one of the preceding claims, further comprising:
a further top transistor structure (50) arranged in the top tier of the CFET device (1) next to the top transistor structure (20), wherein the further top transistor structure (50) comprises:
- at least one top channel (51), and
- a top gate (52) arranged to electrically control the at least one top channel (51);
wherein the at least one top channel (21) of the top transistor structure (20) and the at least one top channel (51) of the further top transistor structure (50) are arranged parallel to each other and at an angle to the at least one bottom channel (11).

10. The CFET device (1) of claim 9, further comprising:
a third buried power rail (44) arranged below the bottom tier of the CFET device (1);
wherein the third buried (44) power rail is electrically connected to a top transistor structure (20) of an adjacent CFET device (1).

11. The CFET device (1) of claim 9 or 10,
wherein a top drain (24) of the top transistor structure (20) is electrically connected to a top source (53) of the further top transistor structure (50).

12. The CFET device (1) of any one of claims 9 to 11,
wherein the top gate of the further top transistor structure (50) is electrically connected to a further bottom gate (12) of the bottom transistor structure (10).

13. A method of fabricating a complementary field effect transistor, CFET, device (1), comprising:
forming a bottom transistor structure (10) in a bottom tier of the CFET device (1), wherein the bottom transistor structure (10) comprises:
- at least one bottom channel (11), and
- a bottom gate (12) arranged to electrically control the at least one bottom channel (11);
forming a top transistor structure (20) in a top tier of the CFET device (1) above the bottom tier, wherein the top transistor structure (20) comprises:
- at least one top channel (21), and
- a top gate arranged to electrically control the at least one top channel (21);
wherein the at least one top channel (21) is arranged at an angle to the at least one bottom channel (11).

14. The method of claim 13, further comprising the step of:
processing at least one vertical connection structure (31) which electrically connects the bottom transistor structure (10) with the top transistor structure (20).

15. The method of claim 14,
wherein the bottom transistor structure (10) is formed on a first substrate (71) and wherein the top transistor structure (20) is formed on a second substrate (72);
wherein complementary sections of the at least one vertical connection structure (31) are formed on the first substrate (71) and on the second substrate (72);
wherein the second substrate (72) is positioned above the first substrate (71) such that the complementary sections of the at least one vertical connection structure (31) on the first and the second substrate (71, 72) are aligned to each other; and
wherein the first substrate (71) and the second substrate (72) are subsequently bonded to each other.

16. The method of any one of claims 13 to 15,
forming a further top transistor structure (50) in the top tier of the CFET device (1) next to the top transistor structure (20), wherein the further top transistor structure (50) comprises:
- at least one top channel (51), and
- a top gate (52) arranged to electrically control the at least one top channel (51);
wherein the at least one top channel (21) of the top transistor structure (20) and the at least one top channel (51) of the further top transistor structure (50) are arranged parallel to each other and at an angle to the at least one bottom channel (11).

## Amended claims

### Amended claims in accordance with Rule 137(2) EPC.

1. A complementary field effect transistor, CFET, device (1), comprising:
a bottom transistor structure (10) arranged in a bottom tier of the CFET device (1), wherein the bottom transistor structure (10) comprises:
- at least one bottom channel (11), and
- a bottom gate (12) arranged to electrically control the at least one bottom channel (11);
a top transistor structure (20) arranged in a top tier of the CFET device (1) above the bottom tier, wherein the top transistor structure (20) comprises:
- at least one top channel (21), and
- a top gate arranged to electrically control the at least one top channel (21);
wherein the at least one top channel (21) is arranged perpendicular to the at least one bottom channel (11) in length direction.

2. The CFET device (1) of claim 1, further comprising:
at least one vertical connection structure (31) which is arranged to electrically connect the bottom transistor structure (10) with the top transistor structure (20).

3. The CFET device (1) of claim 2,
wherein the top transistor structure (20) comprises a top drain (24) arranged to electrically contact the at least one top channel (21), and the bottom transistor structure (10) comprises a bottom drain (14) arranged to electrically contact the at least one bottom channel (11);
wherein the top drain (24) of the top transistor structure (20) is electrically connected to the bottom drain (14) of the bottom transistor structure (10) through one of the at least one vertical connection structure (31).

4. The CFET device (1) of any one of the preceding claims, further comprising:
at least one signal routing line (43) arranged above the top tier,
wherein one of the at least one signal routing line (43) is electrically connected to the top transistor structure (20) from the top, and/or a further one of the at least one signal routing line (43) is electrically connected to the bottom transistor structure (10) from the top.

5. The CFET device (1) of claim 4,
wherein the at least one signal routing line (43) is arranged parallel to the at least one top channel (21) and at an angle to the at least one bottom channel (11), or
wherein the at least one signal routing line (43) is arranged parallel to the at least one bottom channel (11) and at an angle to the at least one top channel (21).

6. The CFET device (1) of any one of the preceding claims, further comprising:
a first buried power rail (41) and a second buried power rail (42) arranged below the bottom tier;
wherein the first buried power rail (41) is electrically connected to the bottom transistor structure (10) from below, and wherein the second buried power rail (42) is electrically connected to the top transistor structure (20) from below.

7. The CFET device (1) of claim 6,
wherein the bottom transistor structure (10) comprises a bottom source (13) arranged to electrically contact the at least one bottom channel (11), wherein the first buried power rail (41) is electrically connected to the bottom source (13) by means of a vertical line structure (61); and
wherein the top transistor structure (20) comprises a top source (23) arranged to electrically contact the at least one top channel (21), wherein the second buried power rail (42) is electrically connected to the top source (23) by means of a further vertical line structure (61), wherein the further vertical line structure (61) is arranged to pass by the at least one bottom channel (11) on one side.

8. The CFET device (1) of any one of the preceding claims, further comprising:
a further top transistor structure (50) arranged in the top tier of the CFET device (1) next to the top transistor structure (20), wherein the further top transistor structure (50) comprises:
- at least one top channel (51), and
- a top gate (52) arranged to electrically control the at least one top channel (51);
wherein the at least one top channel (21) of the top transistor structure (20) and the at least one top channel (51) of the further top transistor structure (50) are arranged parallel to each other and at an angle to the at least one bottom channel (11).

9. The CFET device (1) of claim 8, further comprising:
a third buried power rail (44) arranged below the bottom tier of the CFET device (1);
wherein the third buried (44) power rail is electrically connected to a top transistor structure (20) of an adjacent CFET device (1).

10. The CFET device (1) of claim 8 or 9,
wherein a top drain (24) of the top transistor structure (20) is electrically connected to a top source (53) of the further top transistor structure (50).

11. The CFET device (1) of any one of claims 8 to 10,
wherein the top gate of the further top transistor structure (50) is electrically connected to a further bottom gate (12) of the bottom transistor structure (10).

12. A method of fabricating a complementary field effect transistor, CFET, device (1), comprising:
forming a bottom transistor structure (10) in a bottom tier of the CFET device (1), wherein the bottom transistor structure (10) comprises:
- at least one bottom channel (11), and
- a bottom gate (12) arranged to electrically control the at least one bottom channel (11);
forming a top transistor structure (20) in a top tier of the CFET device (1) above the bottom tier, wherein the top transistor structure (20) comprises:
- at least one top channel (21), and
- a top gate arranged to electrically control the at least one top channel (21);
wherein the at least one top channel (21) is arranged perpendicular to the at least one bottom channel (11) in length direction.

13. The method of claim 12, further comprising the step of:
processing at least one vertical connection structure (31) which electrically connects the bottom transistor structure (10) with the top transistor structure (20).

14. The method of claim 13,
wherein the bottom transistor structure (10) is formed on a first substrate (71) and wherein the top transistor structure (20) is formed on a second substrate (72);
wherein complementary sections of the at least one vertical connection structure (31) are formed on the first substrate (71) and on the second substrate (72);
wherein the second substrate (72) is positioned above the first substrate (71) such that the complementary sections of the at least one vertical connection structure (31) on the first and the second substrate (71, 72) are aligned to each other; and
wherein the first substrate (71) and the second substrate (72) are subsequently bonded to each other.

15. The method of any one of claims 12 to 14,
forming a further top transistor structure (50) in the top tier of the CFET device (1) next to the top transistor structure (20), wherein the further top transistor structure (50) comprises:
- at least one top channel (51), and
- a top gate (52) arranged to electrically control the at least one top channel (51);
wherein the at least one top channel (21) of the top transistor structure (20) and the at least one top channel (51) of the further top transistor structure (50) are arranged parallel to each other and at an angle to the at least one bottom channel (11).
